# EUROPÄISCHE PATENTSCHRIFT

(11) **EP 0 749 156 B1**
(45) Veröffentlichungstag und Bekanntmachung des Hinweises auf die Patenterteilung: **11.08.1999**
(21) Anmeldenummer: 95107911.0
(22) Anmeldetag: 23.05.1995
(51) Int. Cl.: H01L 21/60, H01L 27/108

(54) **Halbleiteranordnung mit selbstjustierten Kontakten und Verfahren zu ihrer Herstellung**
Semiconductor device with self-aligned contacts and method of fabrication
Dispositif semi-conducteur comportant des contacts auto-alignés et son procédé de fabrication

(43) Veröffentlichungstag der Anmeldung: 18.12.1996
(73) Patentinhaber: SIEMENS AKTIENGESELLSCHAFT, 80333 München (DE)
(72) Erfinder: Melzner, Hanno, D-85655 Grosshelfendorf (DE)

(56) Entgegenhaltungen:
- EP-A- 0 190 928
- EP-A- 0 435 392
- GB-A- 2 243 951
- US-A- 4 729 969
- MOTOROLA TECHNICAL DEVELOPMENTS, Bd. 12, 1.April 1991 Seiten 17-18, XP 000229244 YEE-CHAUNG SEE ET AL 'AN ALIGNMENT-TOLERANT CONTACT PROCESS USING LANDING PADS'

## Beschreibung

Die Erfindung betrifft eine Halbleiteranordnung mit selbstjustierten Kontakten gemaß dem Oberbegriff des Patentanspruchs 1 und ein Verfahren zu seiner Herstellung.

Eine Halbleiteranordnung mit selbstjustierten Kontakten ist aus der US-A 4,729,969 bekannt. Die dort geschilderte Halbleiteranordnung zeichnet sich durch eine Elektrode oder Kontaktfläche aus, die sich nicht nur oberhalb eines zu kontaktierenden dotierten Bereiches, sondern auch oberhalb eines an diesen angrenzenden isolierten Bereiches erstreckt. Das Kontaktloch ist versetzt gegenüber dem dotierten Bereiche über dem isolierten Bereich angeordnet. Hierdurch ist erreicht, daß bei zwei in einer ersten lateralen Richtung benachbarten zu kontaktierenden dotierten Bereichen, von denen einer eine Kontaktfläche der beschriebenen Art und einer eine Kontaktfläche gewöhnlicher Art, die lediglich oberhalb des dotierten Bereiches angeordnet ist, aufweist, die dotierten Bereiche möglichst nahe nebeneinander positioniert werden können, ohne daß ein Mindestabstand zwischen den entsprechenden Kontakten unterschritten wird. Einer der beiden Kontakte ist dann nämlich gegenüber dem entsprechenden dotierten Bereich in vom anderen Kontakt abgewandter Richtung versetzt über dem entsprechenden isolierten Bereich angeordnet.

Das geschilderte Verfahren hat den Nachteil, daß es bei mehr als zwei in einer ersten lateralen Richtung zueinander benachbarten zu kontaktierenden dotierten Bereichen nicht zum gewünschten Erfolg führt, nämlich daß mehrere benachbarten dotierte Bereiche untereinander einen möglichst geringen Abstand aufweisen. Soll nämlich der Minimalabstand zwischen zwei der entsprechenden Kontakte nicht unterschritten werden, laßt sich auf die beschriebene Weise lediglich der Abstand der beiden entsprechenden dotierten Bereiche verringern. Dagegen muß deren Abstand zu anderen, ihnen benachbarten dotierten Bereichen sogar vergrößert werden, vorausgesetzt, die Abmessungen der dotierten Bereiche in der ersten lateralen Richtung werden nicht vergrößert und zwischen allen Kontakten werden die gleichen Mindestabstände eingehalten. Die vorgeschlagene Gestaltung der Kontaktflächen erlaubt somit nicht, die dotierten Bereiche und die isolierten Bereiche bei minimal zulässigem Abstand zwischen den dotierten Bereichen in einer regelmäßigen Struktur anzuordnen.

Dieses Problem verschärft sich noch, wenn, wie in der US-A 4,729,969 vorgeschlagen, beide Kontakte zweier benachbarter dotierter Bereiche in jeweils entgegengesetzter Richtung gegenüber den dotierten Bereichen versetzt werden. Hierdurch ist zwar - bei gleichem Mindestabstand zwischen den Kontakten - eine weitere Annäherung zweier betroffener dotierter Bereiche aneinander möglich. Jedoch kann dies nur auf Kosten des Abstandes zu anderen, diesen benachbarten dotierten Bereichen geschehen.

Weitere Halbleiteranordnungen sind is den Dokumenten Motorola Tech. Dev. Bd. 12, 1.Apr.1991, Seiten 17-18 EP-A-435392 und EP-A-190928 beschrieben.

Der Erfindung liegt die Aufgabe zugrunde, eine Halbleiteranordnung zu schaffen, bei welcher eine Vielzahl von zu kontaktierenden dotierten Bereichen in einem möglichst geringen Abstand in einer ersten lateralen Richtung regelmäßig zueinander angeordnet sind.

Diese Aufgabe wird durch eine Halbleiteranordnung gemaß Anspruch 1 und ein Verfahren zu seiner Herstellung gemaß Anspruch 8 gelöst. Weiterbildungen der Erfindung sind in den Unteransprüchen gekennzeichnet.

Die Erfindung vermeidet die Nachteile des geschilderten Standes der Technik. Dadurch, daß die Kontaktlöcher jeweils zur selben Seite der dotierten Bereiche versetzt sind, ist es möglich, eine Vielzahl von benachbarten dotierten Bereichen mit Kontakten zu versehen, wobei sowohl der Abstand zwischen allen benachbarten dotierten Bereichen als auch der Abstand zwischen allen benachbarten Kontakten minimiert werden kann. Mit der Erfindung sind Halbleiteranordnungen realisierbar, die sehr regelmäßige Strukturen aufweisen. Insbesondere können die Abstände zwischen den dotierten Bereichen und diejenigen zwischen den Kontaktlöchern jeweils gleich groß sein. Weisen die dotierten Bereiche und die Kontaktlöcher gleiche Abmessungen auf, kann auch der Abstand zwischen den dotierten Bereichen mit demjenigen zwischen den Kontaklöchern übereinstimmen.

In vorteilhafter Weise lassen sich auch Halbleiteranordnungen erfindungsgemäß herstellen, welche an der Oberfläche des Substrats zwischen den dotierten Bereichen leitende Bereiche aufweisen, die von den isolierten Bereichen umschlossen sind. Ein solcher leitender Bereich kann beispielsweise das Gate eines Transistors sein. Die dem leitenden Bereich bzw. dem ihn umgebenden isolierten Bereich auf beiden Seiten benachbarten dotierten Bereiche bilden dann Drain und Source des Transistors.

Die Erfindung eignet sich besonders vorteilhaft zur Realisierung von Halbleiteranordnungen, die gewöhnlich eine starke Regelmäßigkeit in ihrem Aufbau aufweisen und bei denen eine Vielzahl von dicht benachbarten dotierten Bereichen zu kontaktieren ist. Hierzu zählen zum Beispiel Speicheranordnungen und insbesondere dynamische Speicher (DRAMs). Ein-Transistor-DRAM-Speicherzellen weisen bekanntlich einen Auswahltransistor und einen Speicherzellenkondensator auf. Sind die DRAM-Speicherzellen in Stacked-Capacitor-Technik ausgeführt, ist der Speicherzellenkondensator oberhalb des Transistors angeordnet. Erfindungsgemäß kann nun in vorteilhafter Weise sowohl der Bitleitungskontakt zwischen einer Bitleitung und einem der Kanalanschlüsse (Drain oder Source) des Transistors als auch der sogenannte "innere Kontakt" zwischen dem anderen Kanalanschluß des Transistors und dem über dem Transistor angeordneten Speicherzellenkondensator durch den gleichen Prozeß mittels selbstjustierter Kontakte hergestellt werden. Bei selbstjustierten Kontakten wird die Kontaktfläche nicht lithographisch (also phototechnisch), sondern durch bereits vorhandene Strukturen festgelegt.

Die Erfindung ermöglicht insbesondere die Herstellung von Halbleiteranordnungen im sogenannten "Minimalraster". Das Minimalraster ist das Doppelte der sogenannten "minimalen Entwurfsregel". Die minimale Entwurfsregel entspricht der minimalen Ausdehnung einer herzustellenden Struktur sowie dem minimalen Abstand zweier Strukturen, welche mit der jeweils angewendeten Technologie realisierbar sind. Bei im Minimalraster hergestellten Halbleiter-Anordnungen entsprechen die Abmessungen der dotierten Bereiche, der isolierten Bereiche und der Kontaktlöcher sowie der entsprechenden jeweiligen Abstände im wesentlichen der minimalen Entwurfsregel. Abweichungen davon sind auf Fertigungstoleranzen bzw. dem Fachmann bekannte technologieabhängige Einflüsse zurückzuführen.

Besonders günstig ist es für die Herstellung der Halbleiteranordnung im Minimalraster, wenn sich die Kontaktflächen in einer Länge des Doppelten des zwischen zwei Strukturen in der verwendeten Technologie zulässigen sogenannten "maximalen Kantenlagefehlers", beginnend an derjenigen Seite jedes isolierten Bereiches, die dem jeweiligen dotierten Bereich zugewendet ist, über den isolierten Bereich erstrecken. Der Kantenlagefehler ist der gegenseitige Versatz der Kanten zweier herzustellender Strukturen und setzt sich aus Maßfehler und Justagefehler zusammen. Nach einer groben Faustregel beträgt der maximale Kantenlagefehler ein Drittel der oben definierten minimalen Entwurfsregel.

Weisen die Kontaktflachen die soeben geschilderte Gestalt auf, läßt sich eine Halbleiteranordnung im Minimalraster realisieren, da Fehljustierungen bis in die Größenordnung des maximalen Kantenlagefehlers bei der Herstellung der Kontaktlöcher (die wie beschrieben in der ersten lateralen Richtung eine Ausdehnung in der Größe der minimalen Entwurfsregel a haben) ohne weiteres möglich sind, ohne daß ungewünschte Kurzschlüsse zwischen den herzustellenden Strukturen auftreten. Letztere werden vermieden, indem in jedem Fall gewährleistet ist, daß die Ätzung der Kontaktlöcher nur über den entsprechenden Kontaktflächen erfolgt, welche als Ätzstop wirken. Die Kontaktflächen haben bei dieser Ausführungsform der Erfindung eine Ausdehnung in der ersten lateralen Richtung, die der Ausdehnung der Kontaktlöcher (= minimale Entwurfsregel) zuzüglich des Zweifachen des maximalen Kantenlagefehlers entspricht. Eine mittige Anordnung der Kontaktlöcher über den Kontaktflächen ergibt somit einen Abstand zum Rand der Kontaktflächen von jeweils der Länge des maximalen Kantenlagefehlers, sowohl links als auch rechts in der ersten lateralen Richtung.

Die Kontaktflächen sind aus zwei Teilstücken hergestellt, wobei das erste Teilstück derjenige Teil der Kontaktfläche ist, der sich über dem dotierten Bereich erstreckt, und wobei das zweite Teilstück derjenige Teil der Kontaktfläche ist, der sich über dem isolierten Bereich erstreckt. Erfolgt die Herstellung des zweiten Teilstückes in einer Weise, daß dieses sich außerdem, sofern kein Kantenlagefehler auftritt, um mindestens die Länge des maximalen Kantenlagefehlers über dem ersten Teilstück und damit über dem dotierten Bereich erstreckt, ist auch in dem Fall, daß Kantenlagefehler auftreten, gewährleistet, daß sich eine zusammenhängende Kontaktfläche ergibt.

Beispielsweise aus der obengenannten US 4,729,969 ist ein Verfahren bekannt (welches weiter unten beschrieben wird), bei dem erreicht wird, daß das erste Teilstück nur über dem dotierten Bereich gebildet wird, ohne daß dabei Kantenlagefehler gegenüber diesen auftreten. Es läßt sich also erreichen, daß Kantenlagefehler nur bei der Herstellung des zweiten Teilstücks auftreten. Da dieses aber erfindungsgemäß um die Länge des maximalen Kantenlagefehlers das erste Teilstück überlappt und ebensoweit von der nächsten Kontaktfläche entfernt ist, ist gewährleistet, daß es auch bei der Erzeugung der Kontaktflächen im Minimalraster nicht zu Kurzschlüssen zwischen diesen kommt.

Eine derartige Realisierung einer Mehrzahl von selbstjustierten Kontakten im Minimalraster ist bisher weder nach dem geschilderten Stand der Technik noch nach sonstigem Stand der Technik möglich. Sind die Kontaktflächen nämlich, wie üblich, mittig über den dotierten Bereichen angeordnet, erstrecken sie sich sinnvoller Weise, sofern keine Kantenlagefehler auftreten, um die Länge des maximalen Kantenlagefehlers über den isolierten Bereichen auf beiden Seiten jedes der Kontaktlöcher, so daß die Kontaktflachen wiederum eine Ausdehnung von 5/3 der minimalen Entwurfsregel aufweisen und die Kontaktlöcher problemlos auf ihnen plazierbar sind. Würde man diese Struktur im Minimalraster realisieren, ergäbe sich zwischen den Kontaktflachen, sofern keine Kantenlagefehler auftreten, wie beim Gegenstand der Erfindung, ein Abstand in der Größe des maximalen Kantenlagefehlers. Werden nun bei der Herstellung der Halbleiteranordnung zwei benachbarte der Kontaktflächen jeweils in der Weise dejustiert, daß für jede von ihnen ein Kantenlagefehler in Richtung der anderen Kontaktfläche auftritt, so addieren sich diese Kantenlagefehler, so daß es zu einer Überlappung der beiden Kontaktflächen kommen kann.

Werden dagegen beim Stand der Technik, wie gewöhnlich, zwei benachbarte Kontaktflächen mittels desselben photolithographischen Prozesses hergestellt, muß ihr gegenseitiger Abstand gleich der minimalen Entwurfsregel sein. Sie können dann also ebenfalls nicht im Minimalraster realisiert werden.

Daß auch beim Gegenstand der US-A 4,729,969 eine Realisierung im Minimalraster nicht möglich ist, ergibt sich bereits aus der dort gemachten Annahme, daß der Abstand zwischen den Kontakten von demjenigen zwischen den dotierten Bereichen abweicht und eine regelmäßige Anordnung der Kontakte sowie der dotierten Bereiche, wie oben beschrieben, nicht möglich ist.

Beim Gegenstand der Erfindung dagegen kann es zu einem Kurzschluß zwischen zweien der Kontaktflachen nicht kommen, da nur das zweite Teilstück der Kontaktflächen über dem an derselben Seite jedes dotierten Bereiches befindlichen isolierten Bereich photolithographisch erzeugt wird und damit auch nur das zweite Teilstück von Kantenlagefehlern betroffen sein kann und dieses, sofern kein Kantenlagefehler auftritt, einen Abstand in der Größe des maximalen Kantenlagefehlers zur nächsten benachbarten Kontaktfläche aufweist. Die zweiten Teilstücke zweier benachbarter Kontaktflächen weisen dann auch im Minimalraster einen gegenseitigen Abstand der Größe der minimalen Entwurfsregel auf.

Die Erfindung wird im folgenden anhand der Zeichnung näher erläutert:

Figuren 1 bis 3 zeigen Ausführungsformen der Erfindung, nämlich Figuren 1 und 2 in einer Querschnittdarstellung und Figur 3 in Draufsicht.

Figur 4 ist eine Detailansicht der Ausführungsbeispiele in den Figuren 2 und 3, wenn diese im Minimalraster realisert sind.

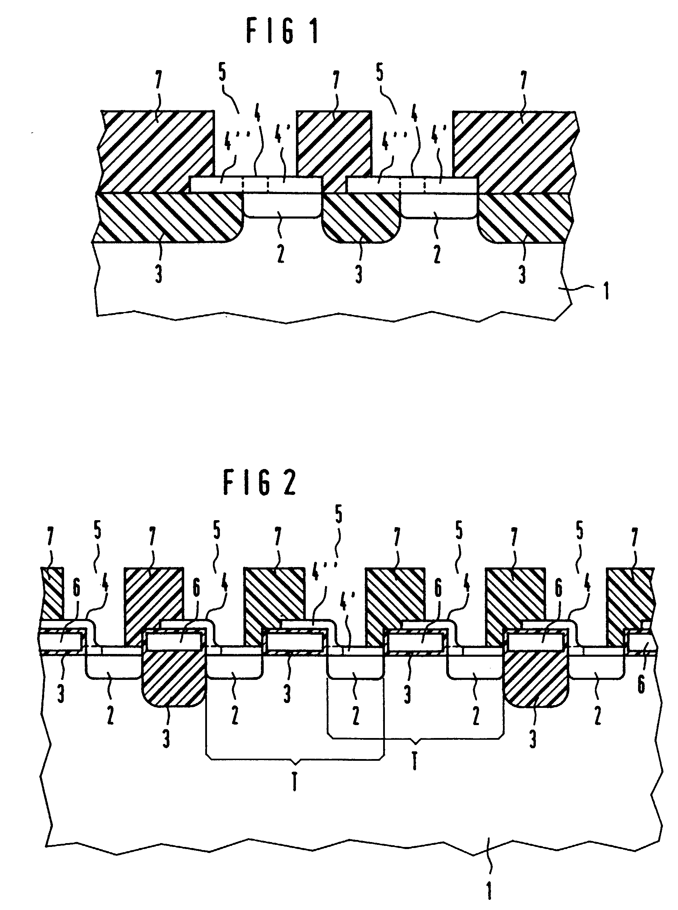

Figur 1 zeigt ein Substrat 1, an dessen Oberfläche sich zwei in einer ersten lateralen Richtung benachbarte dotierte Bereiche 2 befinden. Jeweils links jedes dotierten Bereiches 2 befindet sich ein isolierter Bereich 3, der im Substrat 1 als Trenchisolation ausgeführt ist. Einer dieser beiden isolierten Bereiche 3 befindet sich somit zwischen den beiden dotierten Bereichen 2. Über den dotierten Bereichen 2 auf dem Substrat 1 befinden sich mit ihnen verbundene Elektroden oder Kontaktflächen 4. Die Kontaktflächen 4 erstrecken sich nicht nur über dem jeweiligen dotierten Bereich 2, sondern auch teilweise über jedem links davon befindlichen isolierten Bereich 3. Derjenige Teil jeder Kontaktfläche 4, der sich ausschließlich oberhalb des dotierten Bereiches 2 befindet, wird im folgenden als erstes Teilstück 4' bezeichnet. Derjenige Teil jeder Kontaktfläche 4, der sich oberhalb des isolierten Bereiches 3 befindet, wird als zweites Teilstück 4" bezeichnet. Da beide Teilstücke 4', 4" getrennt voneinander erzeugt werden, muß sich das zweite Teilstück 4" außer über dem isolierten Bereich 3 auch teilweise über dem jeweiligen dotierten Bereich 2 erstrecken, so daß es sich mit dem ersten Teilstück 4' überlappt. Wie weiter unten erläutert wird, ist dieses notwendig, wenn die Halbleiteranordnung im Minimalraster hergestellt wird.

In einer die bisher beschriebenen Strukturen bedeckenden isolierenden Schicht 7 befindet sich über jeder Kontaktfläche 4 je ein Kontaktloch 5 zur Aufnahme von nicht dargestellten Kontakten, die in Form von Kontaktloch-Auffüllungen realisierbar sind. Die Kontaktlöcher 5 sind mittig über den Kontaktflächen 4 angeordnet, also versetzt gegenüber den dotierten Bereichen 2. Es wird angenommen, daß bei der Herstellung der Kontaktlöcher 5 keine Kantenlagefehler aufgetreten sind.

Die Figuren 1 bis 3 stellen Halbleiteranordnungen dar, bei deren Herstellung keine Kantenlagefehler aufgetreten sind. Dies entspricht einem in der Praxis selten zu erreichenden Idealfall. In der Praxis wird es aufgrund von Prozeßungenauigkeiten zu Kantenlagefehlern zwischen den Kontaktlöchern 5 und den Kontaktflachen 4 sowie zwischen den Kontaktflachen 4 und den dotierten Bereichen 2 bzw. isolierten Bereichen 3 kommen. Zur Herstellung der Kontaktflächen 4 müssen Verfahren verwendet werden, die gewährleisten, daß diese sich in der ersten lateralen Richtung über der gesamten Länge der dotierten Bereiche 2 erstrecken (erstes Teilstück 4'), während sie sich nur auf derselben Seite auch oberhalb des entsprechenden isolierten Bereiches 3 erstrecken (zweites Teilstück 4").

Im folgenden wird beschrieben, wie die Halbleiteranordnung in Figur 1 hergestellt wird. Zunächst werden im Substrat 1 die dotierten Bereiche 2 und die isolierten Bereiche 3 erzeugt. Anschließend werden die Kontaktflächen 4 gebildet. Dann wird die isolierende Schicht 7 aufgetragen, woraufhin eine Ätzung der Kontaktlöcher 5 erfolgt. In einem weiteren Schritt können die Kontaktlöcher 5 dann zur Bildung der Kontakte mit einem Material, als welches insbesondere Metall, z. B. Aluminium, in Frage kommt, gefüllt werden.

Verfahren zur Herstellung der beschriebenen Strukturen sowie die Materialien, aus denen sie herstellbar sind, sind dem Fachmann bekannt und werden daher hier nicht näher erläutert. Dargestellt und beschrieben sind nur die für die Beschreibung der Erfindung wesentlichen Strukturen und ihre Herstellung.

Die Kontaktflächen 4 können beispielsweise aus Polysilizium hergestellt werden. Ein entsprechendes Herstellungsverfahren ist in der EP-A 0 567 815 beschrieben. Demzufolge wird eine Polysiliziumschicht aufgebracht, welche im Bereich der zu bildenden Kontaktflächen 4, beispielsweise mit Bor, dotiert wird, woraufhin das nicht dotierte Polysilizium durch eine geeignete Ätzung (z. B. eine Naßätzung, beispielsweise mit KOH) selektiv zum Bor-dotierten Polysilizium entfernt wird. Die Dotierung des Polysiliziums über den dotierten Bereichen 2 (erstes Teilstück 4') erfolgt automatisch durch Diffusion von Bor aus den dotierten Bereichen 2, wenn letztere mit Bor dotiert sind. Das erste Teilstück 4' kann also ohne Auftreten von Kantenlagefehlern erzeugt werden, da nur eine Dotierung im Bereich des zweiten Teilstückes 4'' erfolgen muß.

Eine andere Möglichkeit zur Herstellung der Kontaktflächen 4 ist die Bildung eines Metallsilizids. Bekannterweise wird zur Bildung eines Metallsilizids zunächst eine Metallschicht aufgebracht und anschließend eine strukturierte Polysiliziumschicht. Anschließend wird eine Temperung vorgenommen, wodurch sich das Metall, beispielsweise Titan, und das Polysilizium zu einem Silizid verbinden. Es ist auch möglich, zunächst eine Polysiliziumschicht aufzubringen und anschließend eine strukturierte Metallschicht. Beide Varianten sind in der US-A 4,729,969 beschrieben. Polysilizium muß in beiden Fällen nur dort strukturiert aufgebracht werden, wo die zu bildenden Kontaktflachen 4 sich oberhalb der isolierten Bereiche 3 erstrecken und außerdem ein Stück weit über dem entsprechenden angrenzenden dotierten Bereich 2 (zweites Teilstück 4"). Bei einem Silizium-Substrat entsteht ein Silizid nämlich oberhalb der dotierten Bereiche 2 (erstes Teilstück 4') durch Salizierung (Bildung eines "Salizids" = "Self Aligned Silicid") automatisch, wenn nach Aufbringung einer Metallschicht eine Temperung vorgenommen wird. Es muß allerdings gewährleistet sein, daß das durch die Salizierung gebildete Silizid (erstes Teilstück 4') und dasjenige, welches durch Auftragen des strukturierten Polysiliziums gebildet wird (zweites Teilstück 4"), sich überlappen. Nur dann wird eine zusammenhängende Kontaktfläche 4 gebildet.

Gleiches gilt für die zuvor geschilderten Kontaktflachen 4 aus dotiertem Polysilizium: Dort muß eine Überlappung des dotierten Teiles der Polysiliziumschicht (zweites Teilstück 4") mit den dotierten Bereichen 2 gewährleistet sein. Die Breite der Überlappungszone muß also mindestens dem maximalen Kantenlagefehler entsprechen, damit Fehljustagen nicht dazu führen, daß die beiden Teilstücke 4', 4" sich nicht überlappen, um eine gemeinsame Kontaktfläche 4 zu bilden.

Es ist wichtig, daß bei der anisotropen Ätzung der Kontaktlöcher 5 nur über den Kontaktflächen 4, welche als Ätzstop dienen, geätzt wird und nicht neben diesen. Andernfalls würden die isolierten Bereiche 3 oder das Substrat durch die Ätzung beschädigt und es könnte zu Kurzschlüssen zwischen den herzustellenden Strukturen kommen. Aus diesem Grunde müssen die Kontaktflächen 4 größere Abmessungen als die Kontaktlöcher 5 haben, so daß eine Fehljustierung der Kontaktflachen 4 und der Kontaktlöcher 5 gegeneinander unerheblich ist. Die notwendige Länge desjenigen Teiles jeder Kontaktfläche 4, welcher sich über dem entsprechenden isolierten Bereich 3 befindet (zweites Teilstück 4"), hängt unter anderem von den gewünschten Abmessungen der Kontaktlöcher 5 ab. Sie muß so festgelegt werden, daß ein bei der Herstellung der Kontaktlöcher 5 auftretender Kantenlagefehler gegenüber den Kontaktflächen 4 unschädlich ist.

Die in Figur 1 und der noch zu beschreibenden Figur 2 dargestellten Strukturen können in der ersten lateralen Richtung gleiche Abmessungen aufweisen. Dies ist beispielsweise der Fall, wenn sie im Minimalraster realisiert werden: In der ersten lateralen Richtung entsprechen die Abmessungen der dotierten Bereiche 2, der isolierten Bereiche 3 (bzw. der leitenden Bereiche 6 in Figur 2), der Kontaktlöcher 5 und der Stege in der isolierenden Schicht 7 zwischen den Kontaktlöchern 5 dann im wesentlichen einer minimalen Entwurfsregel a der Technologie, mit welcher die Herstellung der Halbleiteranordnung erfolgt. In diesem Fall ist es vorteilhaft, wenn die Kontaktflachen 4 sich in einer Länge des Doppelten des maximalen Kantenlagefehlers über den isolierten Bereichen 3 erstrecken. Sie haben dann jeweils insgesamt eine Breite von 5/3 der minimalen Entwurfsregel a: 3/3 a über dem dotierten Bereich 2 und 2/3 a über dem benachbarten isolierten Bereich 3.

Als Folge dessen ergibt sich ein zulässiger Kantenlagefehler bei der Herstellung der Kontaktlöcher 5 gegenüber den Kontaktflächen 4 in der Größe des maximalen Kantenlagefehlers, jeweils links und rechts in der ersten lateralen Richtung. Da der Abstand zwischen den Kontaktflachen 4 überall mindestens gleich dem maximalen Kantenlagefehler ist, ist ihre Justierung ebenfalls unkritisch. Hieraus folgt, daß eine unproblematische Realisierung der Halbleiteranordnung im Minimalraster möglich ist, auch wenn beliebig viele zu kontaktierende dotierte Bereiche 2 wie beschrieben nebeneinander angeordnet sind.

Figur 2 zeigt eine ähnliche Halbleiteranordnung wie Figur 1. Jedoch sind diesmal mehrere in der ersten lateralen Richtung benachbarte, voneinander beabstandete dotierte Bereiche 2 mit den entsprechenden isolierten Bereichen 3, den Kontaktflächen 4 sowie den Kontaktlöchern 5 dargestellt. Im Gegensatz zu Figur 1 befinden sich die isolierten Bereiche 3 über dem Substrat 1. Lediglich zwei der dargestellten isolierten Bereiche 3 erstrecken sich in Form einer Trenchisolation auch in das Substrat 1. Über dem Substrat 1 umschließen die isolierten Bereiche 3 je einen gegen das Substrat 1 isolierten leitenden Bereich 6. Die beiden mittleren leitenden Bereiche 6 können beispielsweise die Gates zweier Transistoren T sein, wobei der mittlere der dotierten Bereiche 2 einen gemeinsamen Kanalanschluß (Drain oder Source) dieser Transistoren T darstellt. Die Isolation der leitenden Bereiche 6 gegenüber dem Substrat 1 entspricht in diesem Fall einem Gateoxid. Über die entsprechenden Kontakt löcher 5 sind sowohl der gemeinsame Kanalanschluß der beiden Transistoren T als auch die durch die beiden äußeren dotierten Bereiche 2 gebildeten weiteren Kanalanschlüsse der Transistoren T kontaktierbar. Die diese beiden Transistoren T benachbarten isolierten Bereiche 3, die sich auch in das Substrat 1 erstrecken, stellen Feldoxidbereiche dar.

Eine derartige Konstellation von Transistoren T findet sich beispielsweise in DRAM's, deren Speicherzellen in Stacked-Capacitor-Technik ausgeführt sind und bei denen die Transistoren je zweier Speicherzellen über einen gemeinsamen Bitleitungskontakt verfügen. Faßt man Figur 2 als Darstellung einer solchen Anordnung auf, dann ist der mittlere dotierte Bereich 2 über einen Bitleitungskontakt, der durch Auffüllung des entsprechenden Kontaktloches 5 gebildet wird, mit einer Bitleitung verbindbar. Die beiden äußeren dotierten Bereiche 2 sind über die jeweiligen Kontaktlöcher 5 und sogenannte "innere Kontakte" mit je einem Stacked Capacitor verbindbar.

Die Erfindung ermöglicht es nun, wie bereits dargelegt, daß die gesamte Anordnung im Minimalraster hergestellt wird. Das heißt, die Abmessungen der leitenden Bereiche 6, der dotierten Bereiche 2 und der Kontaktlöcher 5 sowie der zwischen letzteren befindlichen Segmente der isolierenden Schicht 7 entsprechen in der ersten lateralen Richtung (unter Berücksichtigung von Fertigungstoleranzen) im wesentlichen der minimalen Entwurfsregel a, die nur von der verwendeten Technologie abhängig ist.

Erreicht wird dies dadurch, daß die Kontaktflachen 4 eine Ausdehnung von 5/3 der minimalen Entwurfsregel a aufweisen. Die Justierung der Kontaktlöcher 5 zu den Kontaktflächen 4 kann dann mit der Ungenauigkeit des maximalen Kantenlagefehlers von 1/3 der minimalen Entwurfsregel a erfolgen, ohne daß eine Beschädigung der isolierten Bereiche 3 oder des Substrats 1 mit der Folge eines möglichen Kurzschlusses auftreten kann. Die Kontaktlöcher 5 sind also, wenn keine Kantenlagefehler auftreten, um 1/3 der minimalen Entwurfsregel a in der ersten lateralen Richtung versetzt gegenüber den dotierten Bereichen 2 angeordnet.

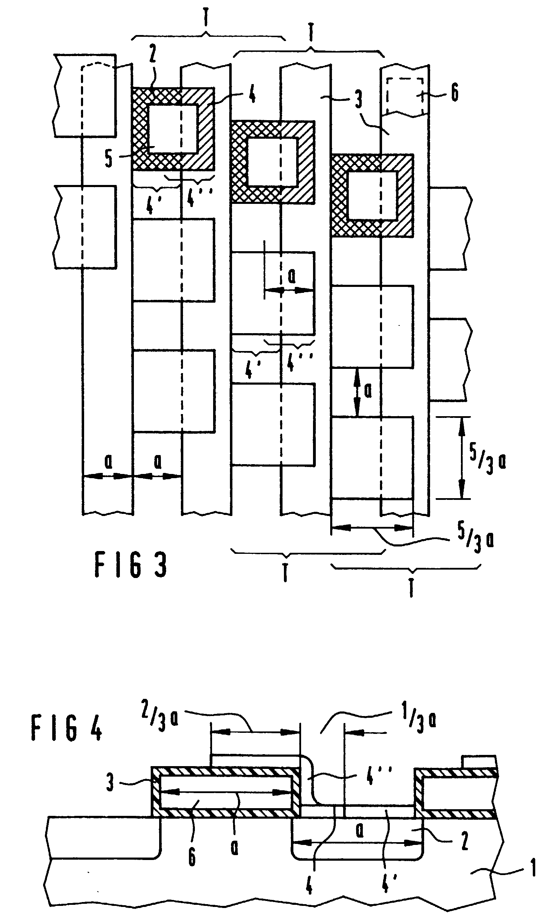

Figur 3 zeigt die oben bereits angesprochene Realisierung der Speicherzellen eines DRAMs in Stacked-Capacitor-Technik. Die Darstellung ist rein schematisch und nur bezüglich der Transistoren T zweier Speicherzellen mit gemeinsamem Bitleitungskontakt genauer ausgeführt, entsprechend den Erläuterungen zu Figur 2. Die diese Transistoren T bildenden dotierten Bereiche 2 sind in einer zweiten lateralen Richtung gegeneinander versetzt angeordnet, wobei bei diesem Ausführungsbeispiel die zweite laterale Richtung senkrecht zur ersten lateralen Richtung verläuft. Zur Verdeutlichung wurden die Abmessungen der dargestellten Strukturen in die Figur 3 eingetragen, bezogen auf die minimale Entwurfsregel a. Diese entspricht, wie bereits gesagt, der Hälfte des Minimalrasters der zur Herstellung der Halbleiteranordnung verwendeten Technologie.

Angedeutet ist in Figur 3, daß die Speicherzellen regelmäßig angeordnet sind. Zwei den in Figur 3 hervorgehoben dargestellten Auswahltransistoren T benachbarte Auswahltransistoren mit gemeinsamem Bitleitungskontakt sind beispielsweise folgendermaßen angeordnet: Man verschiebt die hervorgehobenen Transistoren T um das Minimalraster, also um 2a, zunächst nach unten und dann ebensoweit nach links. Auf diese Weise erhält man eine Speichermatrix mit gegeneinander versetzten Speicherzellen.

Angedeutet sind in einer Draufsicht vier parallel angeordnete, langgestreckte isolierte Bereiche 3. Einer der von diesen umschlossenen leitenden Bereiche 6 ist in Figur 3 im oberen Teil des rechten isolierten Bereiches 3 gestrichelt angedeutet. Die leitenden Bereiche 6 bilden bei diesem Ausführungsbeispiel Wortleitungen des DRAMs, sie sind gleichzeitig die Gates der Speicherzellentransistoren T.

Die Speicherzellentransistoren T sind in einem sogenannten "Quarter Pitch Layout" angeordnet. Das heißt, die sie bildenden dotierten Bereiche 2 sind in der zweiten lateralen Richtung gegeneinader versetzt. Beim Ausführungsbeispiel in Figur 3 wurde dieser Versatz (er beträgt 2/3 a)in vorteilhafter Weise so gewählt, daß sich eine optimierte Anordnung der Transistoren T ergibt. Es lassen sich dann nämlich die im folgenden beschriebenen fehlertoleranten Abstände zwischen den herzustellenden Strukturen realisieren. Insbesondere ist durch dieses Quarter Pitch Layout die Justierung der Kontaktlöcher 5 in Richtung des Verlaufs der Wortleitungen unkritisch. Eine problemlose Justierung der Kontaktlöcher 5 senkrecht dazu wird durch die erfindungsgemäße, bezüglich der dotierten Bereiche 2 asymmetrische bzw. exzentrische Gestaltung der Kontaktflächen 4 erreicht.

Zwischen je zwei der Wortleitungen befindet sich eines der dotierten Gebiete 2, welches reckteckig ist. Die Kontaktflächen 4 sind dagegen quadratisch und erstrecken sich nicht nur über diesen dotierten Bereichen 2, sondern auch ein Stück über den jeweils rechts benachbarten isolierten Bereichen 3.

Die Breite der isolierten Bereiche 3 bzw. der leitenden Bereiche 6 und ihre Abstände zueinander sind gleich der minimalen Entwurfsregel a. Die Abmessungen der dotierten Bereiche 2 sind in Richtung des Verlaufs der Wortleitungen gleich 5/3 der minimalen Entwurfsregel a und in dazu senkrechter Richtung gleich der minimalen Entwurfsregel a. Die Kontaktflächen 4 sind quadratisch mit einer Kantenlänge von 5/3 der minimalen Entwurfsregel a. Sie erstrecken sich also um 3/3 der minimalen Entwurfsregel a über den entsprechenden dotierten Bereich 2 und um 2/3 der minimalen Entwurfsregel a über den jeweiligen isolierten Bereich 3. Ihr gegenseitiger Abstand beträgt in Richtung des Verlaufs der Wortleitungen (beziehungsweise der isolierten Bereiche 3 und der leitenden Bereiche 6) der minimalen Entwurfsregel a und senkrecht dazu dem maximalen Kantenlagefehler von 1/3 der minimalen Entwurfsregel a.

Die Kontakt löcher 5 sind ebenfalls quadratisch und ihre Kantenlänge ist gleich der minimalen Entwurfsregel a. Da bei genauer Justage der Kontakt löcher 5 auf den Kontaktflächen 4 in jede Richtung ein Sicherheitsabstand in der Größe des maximalen Kantenlagefehlers besteht und die Kontaktflachen 4 gegeneinander mindestens einen Abstand in derselben Größe aufweisen, ist die Herstellung einer fehlerfreien Halbleiteranordnung im Minimalraster selbst bei Auftreten des maximalen Kantenlagefehlers gewährleistet.

Werden die Kontaktflachen 4 beispielsweise aus einem Metallsilizid hergestellt, indem zuerst eine Metallschicht aufgetragen wird, ist es ausreichend, wenn Polysilizium nur auf den isolierten Bereichen 3 und am Rand der dotierten Bereiche 2 (zweites Teilstück 4" der Kontaktflächen 4) aufgebracht wird, da bei der Temperung über dem dotierten Bereich (erstes Teilstück 4') automatisch durch Salizierung Silizid gebildet wird. Es muß lediglich gewährleistet werden, daß das "Salizid" und das Silizid, welches über den isolierten Bereichen 3 gebildet wird, sich überlappen. Dazu muß das Polysilizium also, gemessen vom jeweiligen isolierten Bereich 3, mindestens um den maximalen Kantenlagefehler auch über dem dotierten Bereich 2 aufgebracht werden. Entsprechendes gilt für die Herstellung der Kontaktflächen 4 aus Bor-dotiertem Polysilizium.

Figur 4 zeigt eine Detailansicht der Ausführungsbeispiele der Figuren 2 und 3 in einer Querschnittdarstellung für den Fall, daß diese im Minimalraster hergestellt sind und dabei kein Kantenlagefehler aufgetreten ist. Dargestellt sind im wesentlichen einer der dotierten Bereiche 2 und der entsprechende isolierte Bereich 3. Beide haben (ebenso wie die in Figur 4 nicht dargestellten Kontaktlöcher 5) im Minimalraster in der ersten lateralen Richtung die Ausdehnung der minimalen Entwurfsregel a. Die Kontaktfläche 4 weist das erste Teilstück 4' und das zweite Teilstück 4" auf, wobei sich das erste Teilstück 4' ausschließlich über dem dotierten Bereich 2 in einer Länge von etwa der minimalen Entwurfsregel a erstreckt. Das zweite Teilstück 4" hat ebenfalls die Ausdehnung a und erstreckt sich in einer Länge von 2/3 a über dem isolierten Bereich 3 und in einer Länge von 1/3 a über dem dotierten Bereich 2, so daß es hier zu einem Überlapp um 1/3 a zwischen dem ersten 4' und dem zweiten 4" Teilstück kommt.

Es ist zu beachten, daß durch Fertigungstoleranzen Abweichungen der beschriebenen Abmessungen und Abstände zu erwarten sind. Insbesondere ist es möglich, daß sich einige der isolierten Bereiche 3 teilweise auch über den dotierten Bereichen 2 erstrecken. Dies kann durch seitliche Diffusion der Dotieratome in den dotierten Bereichen 2 geschehen oder, wenn die leitenden Bereiche 6 vorgesehen sind, durch deren seitliche Isolation ("Spacer"), die Bestandteil der isolierten Bereiche 3 sind.

Es ist selbstverständlich, daß sich die Erfindung auch zur Herstellung von Speicherzellen eignet, die jeweils einen getrennten Bitleitungskontakt aufweisen.

Durch technologische Randbedingungen kann es erforderlich sein, die Strukturen abweichend von Figur 3 nicht im Minimalraster zu entwerfen. Beispielsweise ist bei einem DRAM ein etwas längerer Transistor zur Erhöhung der Sperrfestigkeit und damit der Datenhaltezeit üblich. Da die erfindungsgemäße Anordnung jedoch sogar einen Entwurf im Minimalraster ermöglicht, sind neben den erwähnten technologischen Randbedingungen keine weitergehenden Einschränkungen im Entwurf gegeben. Technologische Verbesserungen können demnach in vollem Maß umgesetzt werden. Gelingt es beispielsweise, die Sperrfestigkeit der Transistoren auch bei Transistorlängen in der Größe der minimalen Entwurfsregel a sicherzustellen, so kann die Speicherzelle um den resultierenden Flächenanteil verkleinert werden. Bei einer nicht im Minimalraster entworfenen Halbleiteranordnung können andererseits bei erfindungsgemäßer Herstellung z. B. größere Sicherheitsabstände zwischen den Strukturen vorgesehen werden und damit kann die Prozeßsicherheit erhöht werden.

## Patentansprüche

1. Halbleiterspeicheranordnung mit einer Vielzahl von Speicherzellen ,
- bei der jede Speicherzelle einen MOS-Transistor mit einem allseits isolierten Gate (6) und zwei dotierten Bereichen (2) und einen oberhalb vom Transistor angeordneten Kondensator umfaßt,
- bei der in einer ersten Richtung zwei benachbarte MOS-Transistoren so angeordnet sind, daß sie einen gemeinsamen dotierten Bereich aufweisen und daß jeder dotierte Bereich in der ersten Richtung an jeweils derselben Seite an eine zugeordnete Isolationsstruktur angrenzt, die entweder durch einen isolierten Bereich (3) oder durch ein allseits isoliertes Gate (6) eines Transistors gebildet wird,
- bei dem die dotierten Bereiche (2) und die Isolationsstrukturen in der ersten Richtung im wesentlichen die gleiche Ausdehnung aufweisen,
- bei dem auf jedem der dotierten Gebiete eine Kontaktfläche (4) derart angeordnet wird, daß die Kontaktfläche aus zwei im wesentlichen gleich großen Teilstücken (4', 4'') besteht, wobei das erste Teilstück (4') auf dem dotierten Bereich zwischen den angrenzenden Isolationsstrukturen angeordnet ist, und wobei das zweite Teilstück (4'') auf dem dotierten Bereich und auf der zugeordneten Isolationsstruktur (3) angeordnet ist, so daß sich das erste und das zweite Teilstück im Rahmen von Fertigungstoleranzen in der ersten Richtung um die Längen des maximalen Kantenlagefehlers überlappen,
- bei der über den Kontaktflächen eine isolierenden Schicht (7) angeordnet ist,
- bei der jeder dotierte Bereich über jeweils ein in der isolierenden Schicht (7) angeordnetes Kontaktloch (5) mit einer Bitleitung oder dem Kondensator verbunden ist, wobei des Kontaktloch in der ersten Richtung eine dem dotierten Bereich entsprechende Ausdehnung aufweist und im Rahmen von Fertigungstoleranzen zentriert auf der als Ätzstop wirkenden Kontaktfläche 4) angeordnet ist.

2. Halbleiteranordnung nach Anspruch 1,
bei der die Dimensionierung der dotierten Bereiche (2), der isolierten Bereiche (3) , der Kontaktflächen-Teilstücke (4', 4'') und der Kontaktlöcher (5) im wesentlichen einer minimalen Entwurfsregel (a) einer verwendeten Technologie entspricht, in der die Halbleiteranordnung hergestellt ist.

3. Halbleiteranordnung nach einem der Ansprüche 1 oder 2, bei der
- in der ersten lateralen Richtung die Kontaktflächen einen Abstand von a/3 und die Kontakte (5) einen Abstand von a aufweisen, wobei a die minimalen Entwurfsregel einer verwendeten Technologie angibt,
- in einer zweiten lateralen, zur ersten senkrechten Richtung die Kontaktflächen (4) einen Abstand von a und die Kontakte (5) einen Abstand von 5/3a aufweisen.

4. Halbleiteranordnung nach einem der Ansprüche 1 - 3, bei der einer der dotierten Bereiche (2) gegenüber dem ihm in der ersten lateralen Richtung benachbarten dotierten Bereich (2) in der zweiten lateralen Richtung versetzt angeordnet ist.

5. Halbleiteranordnung nach Anspruch 4,
bei der der Versatz im wesentlichen das Doppelte des maximalen Kantenlagefehlers beträgt.

6. Halbleiteranordnung nach einem der Ansprüche 1 - 5, bei der die Kontaktflächen (4) Metallsilizid enthalten.

7. Halbleiteranordnung nach einem der Ansprüche 1 - 5, bei der die Kontaktflächen (4) Polysilizium enthalten.

8. Herstellverfahren für eine Halbleiteranordnung mit einer Vielzahl von MOS-Transistoren,
- bei dem in einem Substrat (1) isolierte Bereiche (3) erzeugt werden,
- bei dem im Substrat (1) zwei in einer ersten Richtung benachbarte MOS Transistoren derart hergestellt werden, daß ein erstes dotiertes Gebiet des ersten Transistors und ein zweites dotiertes Gebiet des zweiten Transistors zusammenfallen, und daß jeder dotierte Bereich in der ersten Richtung an jeweils derselben Seite an eine zugeordnete Isolationsstruktur angrenzt, die entweder durch einen isolierten Bereich (3) oder durch ein allseits isoliertes Gate (6) eines Transistors gebildet wird,
- bei dem die dotierten Bereiche (2) und die Isolationsstrukturen so hergestellt werden, daß sie in der ersten Richtung im wesentlichen die gleiche Ausdehnung aufweisen,
- bei dem auf jedem der dotierten Gebiete eine Kontaktfläche (4) derart gebildet wird, daß die Kontaktfläche aus zwei im wesentlichen gleich großen Teilstücken (4', 4'') hergestellt wird, wobei das erste Teilstück (4') auf dem gesamten dotierten Bereich zwischen den angrenzenden Isolationsstrukturen hergestellt wird, und wobei das zweite Teilstück (4'') auf dem dotierten Bereich und auf der zugeordneten Isolationsstruktur (3) erzeugt wird, so daß sich das erste und das zweite Teilstück im Rahmen von Fertigungstoleranzen in der ersten lateralen Richtung um die Länge des maximalen Kantenlagefehlers überlappen,
- bei dem anschließend eine isolierende Schicht (7) aufgebracht wird,
- bei dem zu jedem der dotierten Bereiche ein Kontaktloch (5) in die isolierende Schicht (7) geätzt wird, das in der ersten Richtung eine dem dotierten Bereich entsprechende Ausdehnung aufweist und im Rahmen von Fertigungstoleranzen zentriert auf der Kontaktfläche (4) angeordnet ist, wobei die Kontaktfläche als Ätzstop dient.

9. Verfahren nach Anspruch 8, bei dem die dotierten Bereiche (2), die Isolationsstrukturen (3) , die Kontaktflächen-Teilstücke (4', 4'') und die Kontaktlöcher (5) in der ersten Richtung mit der fototechnisch minimal erzeugbaren Länge hergestellt werden.

10. Verfahren nach Anspruch 8 oder 9,
- bei dem zur Herstellung der dotierten Bereiche (2) das Substrat (1) an den entsprechenden Stellen mit Bor dotiert wird,
- bei dem zur Herstellung der Kontaktflächen (4) eine Polysiliziumschicht aufgebracht wird,
- bei dem die Polysiliziumschicht im Bereich des zweiten Teilstücks (4'') der Kontaktflächen (4) mit Bor dotiert wird,
- bei dem das undotierte Polysilizium selektiv zum Bor-dotierten Polysilizium durch Ätzung entfernt wird,
- und bei dem das Bor-dotierte Polysilzium als Atzstop für die Herstellung der Kontaktlöcher (5) in der isolierenden Schicht (7) dient.

11. Verfahren nach Anspruch 8 oder 9,
- bei dem zur Herstellung der Kontaktflächen (4) eine Metallschicht aufgebracht wird,
- bei dem eine Polysiliziumschicht aufgebracht und außerhalb des Bereichs des zweiten Teilstücks (4'') der Kontaktflächen wieder entfernt wird,
- und bei dem zur Erzeugung eines Metallsilizids eine Temperung vorgenommen wird.

## Claims

1. Semiconductor memory arrangement with a plurality of storage cells,
- in which each storage cell comprises a MOS transistor with a gate (6) insulated on all sides and two doped regions (2) and a capacitor arranged above the transistor,
- in which two neighbouring MOS transistors are arranged in a first direction in such a way that they have a common doped region and that each doped region adjoins in the first direction, on the same side in each case, an associated insulation structure which is formed either by an insulated region (3) or by a transistor gate (6) insulated on all sides,
- in which the doped regions (2) and the insulation structures have essentially the same extent in the first direction,
- in which on each of the doped zones, a contact area (4) is arranged in such a way that the contact area consists of two essentially equally large portions (4', 4"), the first portion (4') being arranged on the doped region between the adjoining insulation structures, and the second portion (4") being arranged on the doped region and on the associated insulation structure (3), so that the first portion and the second portion overlap within the bounds of fabrication tolerances in the first direction by the length of the maximum edge position error,
- in which an insulating layer (7) is arranged over the contact areas,
- in which each doped region is connected to a bit line or the capacitor via, in each case, a contact hole (5) arranged in the insulating layer (7), the contact hole having an extent corresponding to the doped region in the first direction and, within the bounds of fabrication tolerances, being arranged centred on the contact surface (4) which acts as an etching stop.

2. Semiconductor arrangement according to Claim 1, in which the dimensioning of the doped regions (2), of the insulated regions (3), of the contact-surface portions (4', 4") and of the contact holes (5) corresponds essentially to a minimum design rule (a) of an employed technology in which the semiconductor arrangement is produced.

3. Semiconductor arrangement according to one of Claims 1 and 2, in which
- in the first lateral direction, the contact areas have a spacing of a/3 and the contacts (5) have a spacing of a, a indicating the minimum design rule of an employed technology,
- in a second lateral direction, perpendicular to the first, the contact areas (4) have a spacing of a and the contacts (5) have a spacing of 5/3a.

4. Semiconductor arrangement according to one of Claims 1 - 3, in which one of the doped regions (2) is arranged offset in the second lateral direction relative to the doped region (2) next to it in the first lateral direction.

5. Semiconductor arrangement according to Claim 4, in which the offset is essentially equal to twice the maximum edge position error.

6. Semiconductor arrangement according to one of Claims 1 - 5, in which the contact areas (4) contain metal silicide.

7. Semiconductor arrangement according to one of Claims 1 - 5, in which the contact areas (4) contain polysilicon.

8. Production process for a semiconductor arrangement with a plurality of MOS transistors,
- in which insulated regions (3) are produced in a substrate (1),
- in which two MOS transistors, next to one another in a first direction, are produced in the substrate (1) in such a way that a first doped zone of the first transistor and a second doped zone of the second transistor coincide, and that each doped region adjoins in the first direction, on the same side in each case, an associated insulation structure which is formed either by an insulated region (3) or by a transistor gate (6) insulated on all sides,
- in which the doped regions (2) and the insulation structures are produced in such a way that they have essentially the same extent in the first direction,
- in which a contact area (4) is formed on each of the doped zones in such a way that the contact area is produced by two essentially equally large portions (4', 4"), the first portion (4') being produced over the entire doped region between the adjoining insulation structures, and the second portion (4") being produced on the doped region and on the associated insulation structure (3), so that the first portion and the second portion overlap within the bounds of fabrication tolerances in the first lateral direction by the length of the maximum edge position error,
- in which an insulating layer (7) is then applied,
- in which a contact hole (5), which has an extent corresponding to the doped region in the first direction and is arranged centred on the contact area (4) within the bounds of fabrication tolerances, is etched in the insulating layer (7) to each of the doped regions, the contact area serving as an etching stop.

9. Process according to Claim 8, in which the doped regions (2), the insulation structures (3), the contact-area portions (4', 4"), and the contact holes (5) are produced in the first direction with the minimum phototechnically producible length.

10. Process according to Claim 8 or 9,
- in which the substrate (1) is doped with boron at the corresponding locations in order to produce the doped regions (2),
- in which a polysilicon layer is applied in order to produce the contact areas (4),
- in which the polysilicon layer is doped with boron in the region of the second portion (4") of the contact areas (4),
- in which the undoped polysilicon is removed selectively with respect to the boron-doped polysilicon by etching,
- and in which the boron-doped polysilicon is used as an etching stop for the production of the contact holes (5) in the insulating layer (7).

11. Process according to Claim 8 or 9,
- in which a metal layer is applied in order to produce the contact areas (4),
- in which a polysilicon layer is applied and then removed outside the region of the second portion (4") of the contact areas,
and in which a heat treatment is carried out in order to produce a metal silicide.

## Revendications

1. Dispositif à semi-conducteur comportant une multiplicité de cellules de mémoire, dans lequel
- chaque cellule de mémoire comprend un transistor MOS avec une grille (6) isolée de tous les côtés et avec deux zones dopées (2) et un condensateur disposé au-dessus du transistor,
- il est disposé dans une première direction deux transistors MOS voisins de telle sorte qu'ils comportent une zone dopée commune et que chaque zone dopée est adjacente dans la première direction à chaque fois du même côté à une structure isolante associée qui est formée soit par une zone isolée (3) soit par une grille (6), isolée de tous les côtés, d'un transistor,
- les zones dopées (2) et les structures isolantes ont sensiblement la même étendue dans la première direction,
- il est disposé sur chacune des régions dopées une surface de contact (4) de telle sorte que la surface de contact est constituée de deux tronçons (4', 4") sensiblement de même grandeur, le premier tronçon (4') étant disposé sur la zone dopée entre les structures isolantes adjacentes et le deuxième tronçon (4") étant disposé sur la zone dopée et sur la structure isolante (3) associée de telle sorte que le premier et le deuxième tronçon se chevauchent, dans le cadre de tolérances de fabrication, dans la première direction sur une longueur correspondant à l'erreur de position d'arêtes maximale,
- une couche isolante (7) est disposée au-dessus des surfaces de contact,
- chaque zone dopée est reliée, à chaque fois par l'intermédiaire d'un trou de contact (5) disposé dans la couche isolante (7), à une ligne de bits ou au condensateur, le trou de contact ayant dans la première direction une étendue correspondant à la zone dopée et étant disposé, dans le cadre de tolérances de fabrication, centré sur la surface de contact (4) agissant comme barrière de gravure.

2. Dispositif à semi-conducteur selon la revendication 1, dans lequel le dimensionnement des zones dopées (2), des zones isolées (3), des tronçons de surfaces de contact (4', 4") et des trous de contact (5) correspond sensiblement à une règle de développement minimale (a) d'une technologie utilisée avec laquelle le dispositif à semi-conducteur est fabriqué.

3. Dispositif à semi-conducteur selon l'une des revendications 1 ou 2, dans lequel
- dans la première direction latérale, les surfaces de contact ont une distance de a/3 les unes par rapport aux autres et les contacts (5) ont une distance de a les uns par rapport aux autres, a indiquant la règle de développement minimale d'une technologie utilisée,
- dans une deuxième direction latérale, perpendiculaire à la première, les surfaces de contact (4) ont une distance de a les unes par rapport aux autres et les contacts (5) ont une distance de 5/3 a les uns par rapport aux autres.

4. Dispositif à semi-conducteur selon l'une des revendications 1 à 3, dans lequel l'une des zones dopées (2) est disposée décalée dans la deuxième direction latérale par rapport à la zone dopée (2) qui lui est voisine dans la première direction latérale.

5. Dispositif à semi-conducteur selon la revendication 4, dans lequel le décalage est sensiblement égal au double de l'erreur de position d'arêtes maximale.

6. Dispositif à semi-conducteur selon l'une des revendications 1 à 5, dans lequel les surfaces de contact (4) contiennent un siliciure métallique.

7. Dispositif à semi-conducteur selon l'une des revendications 1 à 5, dans lequel les surfaces de contact (4) contiennent du polysilicium.

8. Procédé de fabrication d'un dispositif à semi-conducteur comportant une multiplicité de transistors MOS, dans lequel
- on produit des zones isolées (3) dans un substrat (1),
- on fabrique dans le substrat (1) deux transistors MOS voisins dans une première direction de telle sorte qu'une première région dopée du premier transistor et une deuxième région dopée du deuxième transistor coïncident et que chaque zone dopée est adjacente dans la première direction à chaque fois du même côté à une structure isolante associée qui est formée soit par une zone isolée (3) soit par une grille (6), isolée de tous les côtés, d'un transistor,
- on fabrique les zones dopées (2) et les structures isolantes de telle sorte qu'elles ont sensiblement la même étendue dans la première direction,
- on forme sur chacune des régions dopées une surface de contact (4) en fabriquant la surface de contact à partir de deux tronçons (4', 4") sensiblement de même grandeur, le premier tronçon (4') étant fabriqué sur toute la zone dopée entre les structures isolantes adjacentes et le deuxième tronçon (4") étant produit sur la zone dopée et sur la structure isolante (3) associée de telle sorte que le premier et le deuxième tronçon se chevauchent, dans le cadre de tolérances de fabrication, dans la première direction latérale sur une étendue correspondant à l'erreur de position d'arêtes maximale,
- on applique ensuite une couche isolante (7),
- sur chacune des zones dopées, on grave dans la couche isolante (7) un trou de contact (5) qui a dans la première direction une dimension correspondant à la zone dopée et qui est disposé, dans le cadre de tolérances de fabrication, centré sur la surface de contact (4), la surface de contact servant de barrière de gravure.

9. Procédé selon la revendication 8, dans lequel on fabrique les zones dopées (2), les structures isolantes (3), les tronçons de surfaces de contact (4', 4") et les trous de contact (5) avec, dans la première direction, la longueur minimale pouvant être produite par une technique photographique.

10. Procédé selon la revendication 8 ou 9, dans lequel
- pour la fabrication des zones dopées (2), on dope avec du bore le substrat (1) aux endroits appropriés,
- pour la fabrication des surfaces de contact (4), on applique une couche de polysilicium,
- on dope avec du bore la couche de polysilicium dans la zone du deuxième tronçon (4") des surfaces de contact (4),
- on élimine par gravure le polysilicium non dopé de manière sélective par rapport au polysilicium dopé au bore,
- et on utilise le polysilicium dopé au bore comme barrière de gravure pour la fabrication des trous de contact (5) dans la couche isolante (7).

11. Procédé pour la revendication 8 ou 9, dans lequel
- pour la fabrication des surfaces de contact (4), on applique une couche métallique,
- on applique une couche de polysilicium et on l'élimine de nouveau en dehors de la zone du deuxième tronçon (4") des surfaces de contact,
- et on effectue une trempe pour la production d'un siliciure métallique.
